# EUROPÄISCHE PATENTANMELDUNG

(11) **EP 4 647 728 A1**
(43) Veröffentlichungstag der Anmeldung: **12.11.2025**
(21) Anmeldenummer: 25174262.3
(22) Anmeldetag: 05.05.2025
(51) Int. Cl.: G01D 11/24, G01D 5/14, G01D 5/20, H05K 3/00

(54) **DREHWINKELSENSORVORRICHTUNG UND MODULARES BAUKASTENSYSTEM ZUR HERSTELLUNG EINER DREHWINKELSENSORVORRICHTUNG**

(30) Priorität: 07.05.2024 DE 102024112734
(71) Anmelder: HELLA GmbH & Co. KGaA, 59552 Lippstadt (DE)
(72) Erfinder: BADER, Manuel, 34431 Marsberg (DE); KUHLMANN, Sascha, 59590 Geseke (DE); MAßMANN, Clemens, 59329 Wadersloh (DE); MÜLLER, Andreas, 33142 Büren (DE); TEGETMEYER, Thomas, 33106 Paderborn (DE)
(74) Vertreter: Behr-Wenning, Gregor

(57) **Zusammenfassung**

Die vorliegende Erfindung betrifft eine Drehwinkelsensorvorrichtung (100) umfassend: eine Trägerbaugruppe (1) mit einem Trägerbaugruppengrundkörper (1.1), der einen Rotorraum (1.2) bildet, eine Rotorbaugruppe (2), die drehbar gegenüber der Trägerbaugruppe (1) in dem Rotorraum (1.2) angeordnet ist, eine erste und zweite Leiterplattenbaugruppe (3), jeweils die an der Trägerbaugruppe (1) befestigt ist, wobei die erste Leiterplattenbaugruppe (3) eine Erfassungseinrichtung (3.2) umfasst, die mit der drehbaren Rotorbaugruppe (2) zur Drehwinkelerfassung zusammenwirkt, wobei die zweite Leiterplattenbaugruppe (4) eine Anschlusskontakteinrichtung (4.2)umfasst, und wobei die Trägerbaugruppe (1) eine Verbindungseinrichtung (1.5) umfasst, die an dem Trägerbaugruppengrundkörper (1.1) befestigt ist und eine elektrische Verbindung zwischen der ersten Leiterplattenbaugruppe (3) und der zweiten Leiterplattenbaugruppe (4) herstellt. Die vorliegende Erfindung betrifft ferner ein modulares Baukastensystem zur Herstellung einer derartigen Drehwinkelsensorvorrichtung (100).

## Beschreibung

Die vorliegende Erfindung betrifft eine Drehwinkelsensorvorrichtung sowie ein modulares Baukastensystem zur Herstellung einer Drehwinkelsensorvorrichtung.

Aus der DE 200 08 200 U1 ist ein Baukastensystem zur Herstellung einer Drehgebervorrichtung bekannt, das eine Auswahl von unterschiedlichen Leiterplattenbaugruppen mit unterschiedlichen Treibern und Schnittstellen umfasst.

Der vorliegenden Erfindung liegt die Aufgabe zugrunde, eine Drehwinkelsensorvorrichtung zu realisieren, die auf einfache Weise für unterschiedliche Anwendungen angepasst werden kann.

Diese Aufgabe wird erfindungsgemäß durch eine Drehwinkelsensorvorrichtung mit den Merkmalen des Anspruchs 1 sowie durch ein modulares Baukastensystem zur Herstellung einer Drehwinkelsensorvorrichtung mit den Merkmalen des Anspruchs 13 gelöst.

Unter einer Baugruppe ist nachfolgend eine aus mehreren fest miteinander verbundenen Einzelteilen bestehende Einheit zu verstehen, die bei der Montage vormontiert beziehungsweise vorgefertigt bereitgestellt und als Ganzes verbaut wird. Unter einer Baugruppe wird hierbei explizit auch eine nicht zerstörungsfrei zerlegbare Einheit verstanden.

Die erfindungsgemäße Drehwinkelsensorvorrichtung umfasst zumindest eine Trägerbaugruppe, eine Rotorbaugruppe und zwei Leiterplattenbaugruppen.

Die Trägerbaugruppe umfasst einen aus einem oder mehreren Teilen bestehenden Trägerbaugruppengrundkörper, der einen vorzugsweise im Wesentlichen zylindrischen Rotorraum bildet, in dem die Rotorbaugruppe angeordnet ist. Die Trägerbaugruppe umfasst ferner eine Verbindungseinrichtung, die an dem Trägerbaugruppengrundkörper befestigt ist und eine elektrische Verbindung zwischen den zwei Leiterplattenbaugruppen herstellt.

Die Verbindungseinrichtung umfasst typischerweise mehrere aus einem elektrisch leitfähigen Material, vorzugsweise aus einem Metall, bestehende Verbindungselemente, die elektrisch voneinander isoliert sind. Die Verbindungselemente sind vorzugsweise in den Trägerbaugruppengrundkörper eingelassen, beispielsweise in entsprechende Öffnungen des Trägerbaugruppengrundkörpers eingesteckt oder durch den Trägerbaugruppengrundkörper umgossen, können jedoch grundsätzlich auch an einer Außenfläche des Trägerbaugruppengrundkörpers angebracht sein. In jedem Fall sind die Verbindungselemente fest mit dem Trägerbaugruppengrundkörper verbunden. Bevorzugt sind die Verbindungselemente stiftförmig ausgebildet und erstrecken sich durch den Trägerbaugruppengrundkörper hindurch. Grundsätzlich können die Verbindungselemente jedoch auf jede beliebige zum Herstellen einer elektrischen Verbindung zwischen den zwei Leiterplattenbaugruppen geeignete Art und Weise ausgebildet sein, beispielsweise als Kontaktflächen, die durch Federkontakte der Leiterplattenbaugruppen kontaktiert werden.

Die Rotorbaugruppe ist vorzugsweise im Wesentlichen kreisscheibenförmig ausgebildet und weist je nach verwendeter Sensortechnologie unterschiedliche charakteristische Merkmale auf, die eine Erfassung eines Drehwinkels der Rotorbaugruppe durch eine geeignet ausgebildete Erfassungseinrichtung der ersten Leiterplattenbaugruppe ermöglichen. Im Falle einer kontaktlosen induktiven Sensortechnologie weist die Rotorbaugruppe beispielsweise eine auf bekannte Art und Weise ausgebildete Kurzschlusswicklung auf, die typischerweise auf einer der ersten Leiterplatte zugewandten Seite eines im Wesentlichen kreisscheibenförmigen, aus einem elektrisch isolierenden Material, vorzugsweise aus einem Kunststoff, bestehenden Rotorbaugruppengrundkörper angeordnet ist. Die Kurzschlusswicklung ist vorzugsweise rotationssymmetrisch bezogen auf eine Drehachse der Rotorbaugruppe ausgebildet und verläuft bevorzugt mäanderförmig um die Drehachse herum. Im Falle einer Magnet-basierten Sensortechnologie weist die Rotorbaugruppe hingegen einen oder mehrere Permanentmagnete auf, die auf bekannte Art und Weise entlang einer Umfangsrichtung der Rotorbaugruppe eine definierte Abfolge von mindestens einem magnetischen Nordpol und mindestens einem magnetischen Südpol erzeugen. Die Rotorbaugruppe weist an einer von der ersten Leiterplattenbaugruppe abgewandten Seite vorzugsweise eine Kopplungseinrichtung zur drehfesten Kopplung der Rotorbaugruppe mit einer Welle oder einem anderen drehbaren Körper, dessen Drehwinkel mit der erfindungsgemäßen Drehwinkelsensorvorrichtung erfasst werden soll, auf.

Die erste Leiterplattenanordnung umfasst eine erste Leiterplatte, die an der Trägerbaugruppe, im Speziellen an dem Trägerbaugruppengrundkörper, befestigt ist und auf der die Komponenten der mit der Rotorbaugruppe zur Erfassung des Drehwinkels der Rotorbaugruppe zusammenwirkenden Erfassungseinrichtung angeordnet sind. Die erste Leiterplatte ist vorzugsweise im Wesentlichen senkrecht zu der Drehachse der Rotorbaugruppe angeordnet. Vorzugsweise bedeckt die erste Leiterplatte diejenige Seite des Trägerbaugruppengrundkörpers, an dem die erste Leiterplatte angeordnet ist, vollständig und ragt dabei vorzugsweise nicht wesentlich seitlich über den Trägerbaugruppengrundkörper hinaus.

Die Erfassungseinrichtung der ersten Leiterplattenbaugruppe weist je nach verwendeter Sensortechnologie unterschiedliche charakteristische Merkmale auf. Im Falle einer kontaktlosen induktiven Sensortechnologie weist die Erfassungseinrichtung beispielsweise mindestens eine um die Drehachse der Rotorbaugruppe umlaufende Senderspule, eine Vielzahl von entlang einer um die Drehachse der Rotorbaugruppe umlaufenden Umfangsrichtung verteilte Empfängerspulen sowie eine Elektronik, die eingerichtet ist, einen Wechselstrom in die Senderspule einzuprägen und eine in die einzelnen Empfängerspulen induzierte Spannung zu erfassen. Im Falle einer Magnet-basierten Sensortechnologie umfasst die Erfassungseinrichtung hingegen einen oder mehrere Magnetfeldsensoren, vorzugsweise einen oder mehrere Hall-Sensoren, zur Erfassung des von dem mindestens einen Permanentmagneten der Rotorbaugruppe erzeugten Magnetfelds.

Die erste Leiterplattenanordnung umfasst ferner eine erste Verbindungskontakteinrichtung, die durch die Verbindungseinrichtung der Trägerbaugruppe elektrisch kontaktiert wird, wobei die erste Verbindungskontakteinrichtung mehrere aus einem elektrisch leitfähigen Material bestehende Verbindungskontakte aufweist, die jeweils in direktem physischem Kontakt mit einem der Verbindungselemente der Verbindungseinrichtung stehen.

Vorzugsweise sind die Verbindungskontakte der ersten Verbindungskontakteinrichtung hierbei als korrespondierend zu den Verbindungselementen der Verbindungseinrichtung ausgebildete Aufnahmen ausgebildet, in die jeweils eines der Verbindungselemente der Verbindungseinrichtung eingreift.

Die zweite Leiterplattenbaugruppe umfasst eine zweite Leiterplatte, die an der Trägerbaugruppe, im Speziellen an dem Trägerbaugruppengrundkörper, befestigt ist und auf der eine Anschlusskontakteinrichtung zum Anschluss der erfindungsgemäßen Drehwinkelsensorvorrichtung an ein externes System angeordnet ist. Die zweite Leiterplatte ist vorzugsweise im Wesentlichen senkrecht zu der Drehachse der Rotorbaugruppe angeordnet. Vorzugsweise weist die zweite Leiterplatte einen seitlich über die Trägerbaugruppe hinausragenden Abschnitt auf, wobei die Anschlusskontakteinrichtung auf dem hinausragenden Abschnitt der zweiten Leiterplatte angeordnet ist. Die zweite Leiterplatte bedeckt vorzugsweise diejenige Seite des Trägerbaugruppengrundkörpers, an dem die zweite Leiterplatte angeordnet ist, vollständig und ragt dabei vorzugsweise, abgesehen von dem hinausragenden Abschnitt der zweiten Leiterplatte, nicht wesentlich seitlich über den Trägerbaugruppengrundkörper hinaus.

Die Anschlusskontakteinrichtung umfasst mehrere aus einem elektrisch leitfähigen Material bestehende Anschlusskontakte, die, vorzugsweise nebeneinanderliegend, auf einer Oberfläche der zweiten Leiterplatte angeordnet sind. Die Anschlusskontakte sind hierbei in einem definierten Abstand zueinander angeordnet, wobei der Abstand zwischen zwei benachbarten Anschlusskontakten auch mit dem englischen Begriff "Pitch" bezeichnet wird. Vorzugsweise sind die Anschlusskontakte als Kontaktflächen ausgebildet. An die Anschlusskontakteinrichtung wird vorzugsweise ein Anschlussstecker angeschlossen, wobei Steckkontakte des Anschlusssteckers jeweils mit einem der Anschlusskontakte der Anschlusskontakteinrichtung elektrisch verbunden sind. Über die Anschlusskontakteinrichtung wird typischerweise elektrische Energie von dem externen System an die erfindungsgemäße Drehwinkelsensorvorrichtung bereitgestellt. Ferner bildet die Anschlusskontakteinrichtung typischerweise eine Datenschnittstelle zur Datenübertragung zwischen der erfindungsgemäßen Drehwinkelsensorvorrichtung und dem externen System, wobei die Datenschnittstelle grundsätzlich auf unterschiedlichen Schnittstellenstandards wie beispielsweise SENT, PSI5 oder CAN basieren kann oder auch ausgelegt sein kann, definierte analoge Signale oder definierte pulsweitenmodulierte Signale zu übertragen.

Die zweite Leiterplattenanordnung umfasst ferner eine zweite Verbindungskontakteinrichtung, die durch die Verbindungseinrichtung der Trägerbaugruppe elektrisch kontaktiert wird, wobei die zweite Verbindungskontakteinrichtung mehrere aus einem elektrisch leitfähigen Material bestehende Verbindungskontakte aufweist, die jeweils in direktem physischem Kontakt mit einem der Verbindungselemente der Verbindungseinrichtung stehen.

Vorzugsweise sind die Verbindungskontakte der zweiten Verbindungskontakteinrichtung hierbei - analog zu den Verbindungskontakten der ersten Verbindungskontakteinrichtung - als korrespondierend zu den Verbindungselementen der Verbindungseinrichtung ausgebildete Aufnahmen ausgebildet, in die jeweils eines der Verbindungselemente der Verbindungseinrichtung eingreift.

Die erfindungsgemäße Drehwinkelsensorvorrichtung kann durch die Verwendung unterschiedlich konfigurierter Rotorbaugruppen, unterschiedlich konfigurierter erster Leiterplattenbaugruppen und/oder unterschiedlich konfigurierter zweiter Leiterplattenbaugruppen auf einfache Weise für unterschiedliche Anwendungen angepasst werden.

Vorzugsweise umfasst die Trägerbaugruppe einen einstückigen Trägerbaugruppengrundkörper, an dem die Verbindungseinrichtung befestigt ist. Bevorzugt ist der Trägerbaugruppengrundkörper hierbei ein mittels eines Gussverfahrens hergestellter Vollkörper. Dies schafft eine relativ einfach herzustellende Trägerbaugruppe.

Bevorzugt besteht der Trägerbaugruppengrundkörper hierbei aus einem elektrisch isolierenden Kunststoff, wobei der Trägerbaugruppengrundkörper vorzugsweise mittels eines Spritzgussverfahrens hergestellt ist. Dies schafft eine relativ einfach herzustellende Trägerbaugruppe. Besonders bevorzugt sind die Verbindungselemente der Verbindungseinrichtung hierbei durch den Trägerbaugruppengrundkörper umspritzt und dadurch zuverlässig an dem Trägerbaugruppengrundkörper befestigt.

In einer bevorzugten Ausführung umfasst die Trägerbaugruppe, im Speziellen der Trägerbaugruppengrundkörper, eine Wandung, die zwischen der Rotorbaugruppe und der ersten Leiterplattenbaugruppe angeordnet ist und verhindert, dass sich die erste Leiterplattenbaugruppe und die Rotorbaugruppe berühren. Ferner kann durch die Wandung, im Speziellen durch die Wandstärke der Wandung, auf einfache Weise ein definierter Abstand zwischen der Rotorbaugruppe und der mit der Rotorbaugruppe zur Drehwinkelerfassung zusammenwirkenden, auf der ersten Leiterplatte der ersten Leiterplattenbaugruppe angeordneten Erfassungseinrichtung festgelegt werden.

Vorzugsweise umfasst die Trägerbaugruppe eine Schnappeinrichtung, durch die die Rotorbaugruppe in dem Rotorraum gehalten wird. Dies ermöglicht eine einfache Montage der Rotorbaugruppe in dem Rotorraum der Trägerbaugruppe. Bevorzugt umfasst die Schnappeinrichtung mehrere entlang eines Umfangs der Rotorbaugruppe verteilt angeordnete Schnappelemente, vorzugsweise sogenannte Schnapphaken, die eine Kante der Rotorbaugruppe umgreifen. Bevorzugt sind die Schnappelemente der Schnappeinrichtung einstückig mit dem Trägerbaugruppengrundkörper ausgebildet. Grundsätzlich kann die Rotorbaugruppe jedoch auch auf eine beliebige andere Art und Weise in dem Rotorraum gehalten werden, beispielsweise mittels einer Bajonetteinrichtung.

In einer bevorzugten Ausführung umfasst die Verbindungseinrichtung von der Trägerbaugruppe hervorstehende Verbindungselemente und weisen die erste Leiterplattenbaugruppe und die zweite Leiterplattenbaugruppe jeweils korrespondierend zu den Verbindungselementen ausgebildete Aufnahmen auf, in die die Verbindungselemente eingreifen. Vorzugsweise sind die hervorstehenden Bereiche der Verbindungselemente hierbei jeweils als Federstecker beziehungsweise Lamellenstecker ausgebildet, um einen zuverlässigen elektrischen Kontakt mit der jeweiligen Aufnahme der Leiterplattenbaugruppe zu realisieren. Vorzugsweise sind die Aufnahmen der beiden Leiterplattenbaugruppen durch Durchgangsöffnungen der ersten Leiterplatte beziehungsweise der zweiten Leiterplatte ausgebildet, durch die sich der hervorstehende Bereich des entsprechenden Verbindungselements hindurch erstreckt.

Bevorzugt sind die erste Leiterplattenbaugruppe und/oder die zweite Leiterplattenbaugruppe über die Verbindungseinrichtung an der Trägerbaugruppe befestigt. Dies ermöglicht eine einfache Montage der ersten Leiterplattenbaugruppe und/oder der zweiten Leiterplattenbaugruppe an der Trägerbaugruppe. Die Befestigung kann hierbei beispielsweise durch als Federstecker beziehungsweise Lamellenstecker ausgebildete Verbindungselemente der Verbindungseinrichtung realisiert werden, wobei die Stecker in entsprechende Durchgangsöffnungen der ersten Leiterplatte beziehungsweise der zweiten Leiterplatte eingesteckt sind, und wobei die Stecker jeweils derart ausgebildet sind, dass die jeweilige Leiterplatte durch die von der Feder beziehungsweise den Lamellen des Steckers auf die jeweilige Leiterplatte ausgeübte Federkraft an der Trägerbaugruppe gehalten wird. Hierdurch kann auf einfache Weise eine zuverlässige und wiederlösbare Befestigung der ersten Leiterplattenbaugruppe und/oder der zweiten Leiterplattenbaugruppe an der Trägerbaugruppe realisiert werden, wobei die jeweilige Leiterplattenbaugruppe auf einfache Weise durch Aufschieben auf die Verbindungselemente an der Trägerbaugruppe montiert werden kann.

In einer bevorzugten Ausführung sind die erste Leiterplattenbaugruppe und die zweite Leiterplattenbaugruppe an gegenüberliegenden Seiten der Trägerbaugruppe angeordnet, sodass die beiden Leiterplattenbaugruppen auf einfache Weise mittels gerader, sich durch den Trägerbaugruppengrundkörper hindurch erstreckender Verbindungselemente miteinander verbunden werden können.

Vorzugsweise sind die erste Leiterplattenbaugruppe und/oder die zweite Leiterplattenbaugruppe derart ausgebildet und angeordnet, dass eine offene Seite des Rotorraums durch die erste Leiterplattenbaugruppe und/oder durch die zweite Leiterplattenbaugruppe zumindest teilweise verdeckt wird, sodass durch die erste Leiterplattenbaugruppe und/oder durch die zweite Leiterplattenbaugruppe ein Herausfallen der Rotorbaugruppe aus dem Rotorraum verhindert wird, ohne dass hierfür zusätzliche Mittel vorgesehen werden müssten. Bevorzugt verdeckt die erste Leiterplattenbaugruppe beziehungsweise die zweite Leiterplattenbaugruppe die jeweilige offene Seite des Rotorraums hierbei im Wesentlichen vollständig, wobei die zweite Leiterplatte der zweiten Leiterplattenbaugruppe jedoch typischerweise eine Durchgangsöffnung aufweist, über die ein Kopplungselement zur drehfesten Kopplung der Rotorbaugruppe in die Kopplungseinrichtung der Rotorbaugruppe eingeführt werden kann.

Bevorzugt umfasst die erste Leiterplattenbaugruppe eine Auswerteelektronik, die auf bekannte Art und Weise ausgebildet ist, basierend auf einem von der Erfassungseinrichtung bereitgestellten, im Allgemeinen analogen Messsignal digitale, einen Drehwinkel angebende Sensordaten zu bestimmen. Typischerweise umfasst die Auswerteelektronik eine Mikrocontroller, einen sogenannten ASIC oder ein sogenanntes FPGA sowie einen Analog-Digital-Wandler, wobei der Analog-Digital-Wandler auch in eine der zuvor genannten Komponenten integriert sein kann.

In einer bevorzugten Ausführung umfasst die erste Leiterplattenbaugruppe oder die zweite Leiterplattenbaugruppe eine Spannungsregeleinrichtung, die elektrisch mit der Anschlusskontakteinrichtung verbunden ist, und die eingerichtet ist, eine definierte, regulierte Versorgungsspannung zum Betreiben von elektrischen und/oder elektronischen Komponenten der ersten Leiterplattenbaugruppe und/oder der zweiten Leiterplattenbaugruppe bereitzustellen. Die Spannungsregeleinrichtung kann beispielsweise eingerichtet sein, eine geregelte Versorgungsspannung von 5 V, 12 V oder 24 V bereitzustellen. Vorzugsweise umfasst die Spannungsregeleinrichtung auch eine oder mehrere Schutzschaltungen, beispielsweise zum Schutz vor elektrostatischer Entladung und/oder zum Schutz vor elektromagnetischer Strahlung.

Vorzugsweise umfasst die erste Leiterplattenbaugruppe oder die zweite Leiterplattenbaugruppe eine weitere Erfassungseinrichtung, die mit der drehbaren Rotorbaugruppe zur Drehwinkelerfassung zusammenwirkt, wobei die weitere Erfassungseinrichtung bevorzugt auf einer anderen Sensortechnologie basiert als die zuvor beschriebene Erfassungseinrichtung. Durch die weitere Erfassungseinrichtung wird eine besonders zuverlässige Drehwinkelerfassung ermöglicht.

Das erfindungsgemäße modulare Baukastensystem zur Herstellung einer zuvor beschriebenen erfindungsgemäßen Drehwinkelsensorvorrichtung umfasst die zuvor beschriebenen Baugruppen, also die Trägerbaugruppe, die Rotorbaugruppe, die erste Leiterplattenbaugruppe und die zweite Leiterplattenbaugruppe, wobei erfindungsgemäß mindestens eine der folgenden Baugruppen in mehreren unterschiedlichen Konfigurationen vorhanden ist: die Rotorbaugruppe, die erste Leiterplattenbaugruppe und die zweite Leiterplattenbaugruppe, wobei jede der unterschiedlichen Konfigurationen ausgelegt ist, an der Trägerbaugruppe montiert zu werden. Bevorzugt ist jede der zuvor genannten Baugruppen in mehreren unterschiedlichen Konfigurationen vorhanden.

Die Rotorbaugruppe und die erste Leiterplattenbaugruppe können beispielsweise jeweils in mehreren Konfigurationen vorhanden sein, die für unterschiedliche Drehwinkelmessbereiche ausgelegt sind und/oder die auf unterschiedlichen Sensortechnologien basieren. Die erste Leiterplattenbaugruppe und die zweite Leiterplattenbaugruppe können ferner beispielsweise jeweils in mehreren Konfigurationen vorhanden sein, die für unterschiedliche Datenschnittstellen und/oder unterschiedliche Versorgungsspannungen ausgelegt sind und/oder die sich hinsichtlich der vorhandenen Komponenten unterscheiden, beispielsweise mit/ohne weitere Erfassungseinrichtung. Des Weiteren ist es beispielsweise auch vorstellbar, dass die zweite Leiterplattenbaugruppe in mehreren Konfigurationen vorhanden ist, die sich hinsichtlich des Abstands, der Anzahl und/oder der Position der Anschlusskontakte der Anschlusskontakteinrichtung unterscheiden, um die Anbindung unterschiedlicher Anschlussstecker zu ermöglichen.

Das erfindungsgemäße modulare Baukastensystem ermöglicht es, auf einfache Weise durch Auswahl unterschiedlicher Konfigurationen der einzelnen Baugruppen eine für unterschiedliche Anwendungen angepasste Drehwinkelsensorvorrichtung herzustellen.

Ein Ausführungsbeispiel der vorliegenden Erfindung wird nachfolgend anhand der beigefügten Figuren beschrieben. Hierbei zeigt:
- Fig. 1: schematisch eine erfindungsgemäße Drehwinkelsensorvorrichtung,
- Fig. 2: schematisch die Drehwinkelsensorvorrichtung aus Fig. 1, jedoch ohne eine erste Leiterplattenbaugruppe
- Fig. 3: schematisch eine Rotorbaugruppe und eine Trägerbaugruppe der Drehwinkelsensorvorrichtung aus Fig. 1,
- Fig. 4: schematisch eine in Fig. 3 nicht sichtbare Oberseite der Rotorbaugruppe,
- Fig. 5: schematisch unterschiedliche bei einem erfindungsgemäßen modularen Baukastensystem zur Herstellung einer Drehwinkelsensorvorrichtung vorhandene Konfigurationen der Rotorbaugruppe.

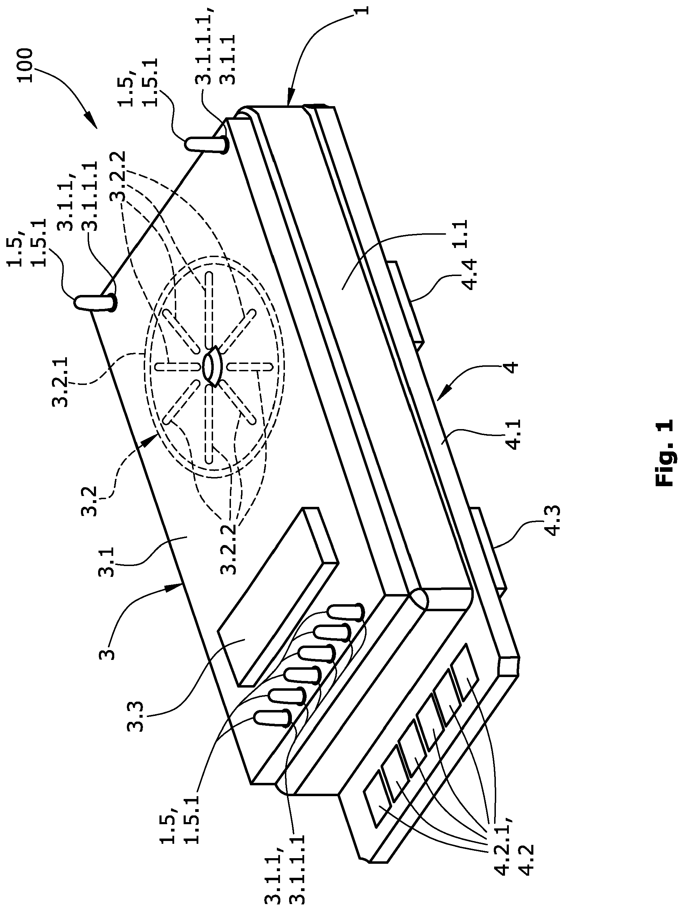

Fig.1 zeigt eine erfindungsgemäße Drehwinkelsensorvorrichtung 100 mit einer Trägerbaugruppe 1, einer Rotorbaugruppe 2, einer ersten Leiterplattenbaugruppe 3 und einer zweiten Leiterplattenbaugruppe 4, wobei die Drehwinkelsensorvorrichtung 100 im vorliegenden Ausführungsbeispiel auf der sogenannten kontaktlosen induktiven Sensortechnologie basiert.

Die Trägerbaugruppe 1 umfasst einen einstückigen Trägerbaugruppengrundkörper 1.1, der aus einem Kunststoff besteht und mittels eines Spritzgussverfahrens hergestellt ist.

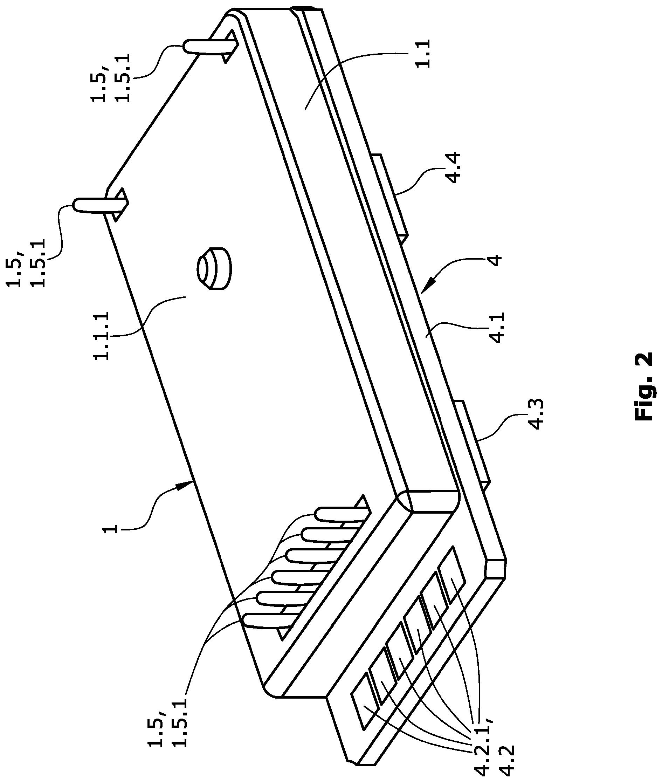

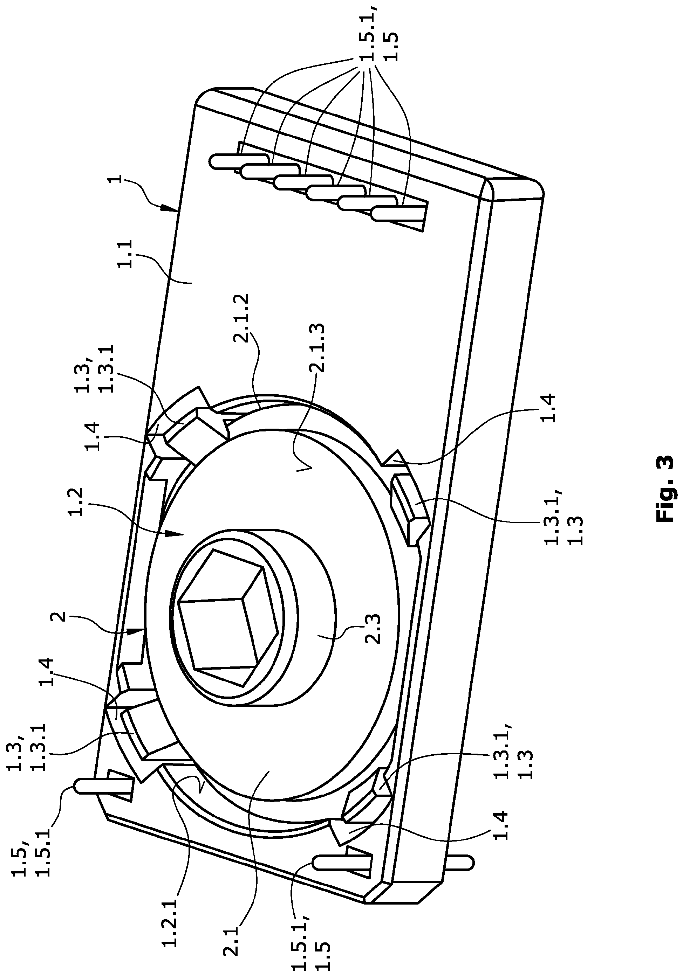

In dem Trägerbaugruppengrundkörper 1.1 ist ein im Wesentlichen zylinderförmiger Rotorraum 1.2 ausgebildet, der auf einer in Fig. 3 dargestellten Unterseite offen ist und auf einer Oberseite durch eine in Fig. 2 dargestellte Deckenwandung 1.1.1 begrenzt ist, die durch den Trägerbaugruppengrundkörper 1.1 gebildet ist.

Die Trägerbaugruppe 1 umfasst eine Schnappeinrichtung 1.3 mit vier Schnappelementen 1.3.1, die einstückig mit dem Trägerbaugruppengrundkörper 1.1 ausgebildet und in einer Umfangswandung 1.2.1 des Rotorraums 1.2 ausgebildeten Taschen 1.4 angeordnet sind und eine Kante 2.1.2 eines Rotorbaugruppengrundkörpers 2.1 der Rotorbaugruppe 2 umgreifen.

Die Trägerbaugruppe 1 umfasst eine Verbindungseinrichtung 1.5 mit acht stiftförmigen, aus einem Metall bestehenden Verbindungselementen 1.5.1, die durch den Trägerbaugruppengrundkörper 1.1 umspritzt und somit an dem Trägerbaugruppengrundkörper 1.1 befestigt sind.

Die Verbindungselemente 1.5 stehen jeweils sowohl an der in Fig. 2 dargestellten Oberseite als auch an der in Fig. 3 dargestellten Unterseite von dem Trägerbaugruppengrundkörper 1.1 hervor, wobei die hervorstehenden Bereiche der Verbindungselemente 1.5.1 jeweils als Federstecker oder als Lamellenstecker ausgebildet sind.

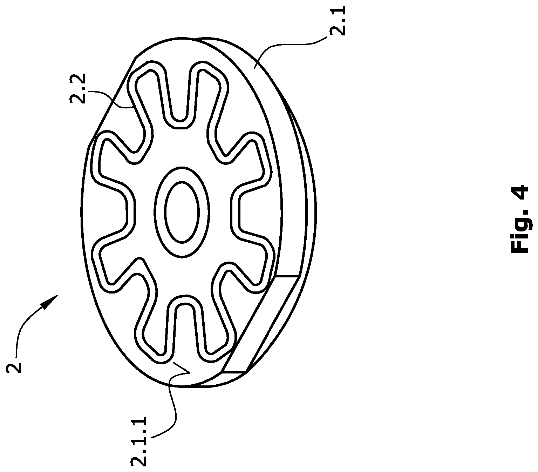

Die Rotorbaugruppe 2 umfasst den Rotorbaugruppengrundkörper 2.1, der aus einem Kunststoff besteht und an dessen in Fig. 4 dargestellter Oberseite 2.1.1 eine mäanderförmig um eine Drehachse der Rotorbaugruppe 2 umlaufend ausgebildete Kurzschlusswicklung 2.2 angeordnet ist.

An einer in Fig. 3 dargestellten Unterseite 2.1.3 des Rotorbaugruppengrundkörpers 2.1 ist eine Kopplungseinrichtung 2.3 zur drehfesten Kopplung der Rotorbaugruppe 2 mit einer Welle oder einem anderen drehbaren Körper, dessen Drehwinkel erfasst werden soll, ausgebildet.

Die Rotorbaugruppe 2 ist mit der Oberseite 2.1.1 des Rotorbaugruppengrundkörpers 2.1 in Richtung der Deckenwandung 1.1.1 des Trägerbaugruppengrundkörpers 1.1 weisend in dem Rotorraum 1.2 angeordnet, wobei die Rotorbaugruppe 2 gegenüber der Trägerbaugruppe 1 drehbar gelagert ist und durch die Schnappeinrichtung 1.3 in dem Rotorraum 1.2 gehalten wird.

Die erste Leiterplattenbaugruppe 3 umfasst eine erste Leiterplatte 3.1, die an einer von dem Rotorraum 1.2 abgewandten Außenseite der Deckenwandung 1.1.1 des Trägerbaugruppengrundkörpers 1.1 anliegt.

Die erste Leiterplatte 3.1 umfasst eine erste Verbindungskontakteinrichtung 3.1.1 mit acht korrespondierend zu den Verbindungselementen 1.5 ausgebildeten und angeordneten Aufnahmen 3.1.1.1, in die jeweils eines der Verbindungselemente 1.5 eingreift und die erste Leiterplatte 3.1 dadurch sowohl elektrisch kontaktiert als auch an dem Trägerbaugruppengrundkörper 1.1 befestigt.

An einer in Fig. 1 nicht sichtbaren Unterseite der ersten Leiterplatte 3.1 ist eine in Fig. 1 gestrichelt angedeutete Erfassungseinrichtung 3.2 angeordnet, die eine Senderspule 3.2.1 und eine Vielzahl von Empfängerspulen 3.2.2 umfasst, und die auf bekannte Art und Weise mit der Kurzschlusswicklung 2.2 der Rotorbaugruppe 2 zur Erfassung eines Drehwinkels der Rotorbaugruppe 2 gegenüber der Trägerbaugruppe 1 zusammenwirkt.

Die erste Leiterplattenbaugruppe 3 umfasst ferner eine Auswerteelektronik 3.3, die auf bekannte Art und Weise ausgebildet ist, basierend auf einem von der Erfassungseinrichtung 3.2 bereitgestellten Messsignal einen den Drehwinkel der Rotorbaugruppe 2 gegenüber der Trägerbaugruppe 1angebende Sensordaten zu bestimmen.

Die zweite Leiterplattenbaugruppe 4 umfasst eine zweite Leiterplatte 4.1, die an der in Fig. 3 dargestellten Unterseite des Trägerbaugruppengrundkörpers 1.1 anliegt und die offene Seite des Rotorraums 1.2 verdeckt, sodass durch die zweite Leiterplatte 4.1 ein Herausfallen der Rotorbaugruppe 2 aus dem Rotorraum 1.2 verhindert wird.

Die zweite Leiterplatte 4.1 umfasst eine hier nicht dargestellte, analog zu der ersten Verbindungskontakteinrichtung 3.1.1 der ersten Leiterplatte 3.1 ausgebildete zweite Verbindungskontakteinrichtung, in deren acht Aufnahmen ebenfalls jeweils eines der Verbindungselemente 1.5 eingreift und die zweite Leiterplatte 4.1 dadurch sowohl elektrisch kontaktiert als auch an dem Trägerbaugruppengrundkörper 1.1 befestigt.

Die zweite Leiterplatte 4.1 ist folglich über die Verbindungselemente 1.5 elektrisch mit der ersten Leiterplatte 3.1 verbunden.

Die zweite Leiterplatte 4.1 umfasst ferner eine hier ebenfalls nicht dargestellte Durchgangsöffnung, über die ein Kopplungselement zur drehfesten Kopplung der Rotorbaugruppe 2 mit der Welle beziehungsweise dem drehbaren Körper, dessen Drehwinkel erfasst werden soll, in die Kopplungseinrichtung 2.3 der Rotorbaugruppe 2 eingeführt werden kann.

Die zweite Leiterplattenbaugruppe 4 umfasst ferner eine auf der zweiten Leiterplatte 4.1 angeordnete Anschlusskontakteinrichtung 4.2 mit sechs aus einem Metall bestehenden Anschlusskontakten 4.2.1 zum Anschluss der Drehwinkelsensorvorrichtung 100 an ein hier nicht dargestelltes externes System.

An der Anschlusskontakteinrichtung 4.2 wird hierbei ein nicht dargestellter Anschlussstecker angeordnet, dessen Steckkontakte jeweils mit einem der Anschlusskontakte 4.2.1 elektrisch verbunden werden, weshalb die Anschlusskontakte 4.2.1 korrespondierend zu Positionen der Steckerkontakte des jeweiligen Anschlusssteckers positioniert sind.

Über die Anschlusskontakteinrichtung 4.2 wird einerseits elektrische Energie von dem externen System an die Drehwinkelsensorvorrichtung 100 bereitgestellt und andererseits bildet die Anschlusskontakteinrichtung 4.2 eine Datenschnittstelle zur Datenübertragung zwischen der Drehwinkelsensorvorrichtung 100 und dem externen System.

Die zweite Leiterplattenbaugruppe 4 umfasst ferner eine Spannungsregeleinrichtung 4.3, die elektrisch mit der Anschlusskontakteinrichtung 4.2 verbunden ist, und der über die Anschlusskontakteinrichtung 4.2 elektrische Energie von dem externen System bereitgestellt wird.

Die Spannungsregeleinrichtung 4.3 ist hierbei auf bekannte Art und Weise eingerichtet, eine definierte Versorgungsspannung an die Auswerteelektronik 3.3 sowie die übrigen elektrischen und elektronischen Komponenten der ersten Leiterplattenanordnung 3 und der zweiten Leiterplattenanordnung 4 bereitzustellen.

Die zweite Leiterplattenbaugruppe 4 umfasst ferner eine weitere Erfassungseinrichtung 4.4, beispielsweise eine magnetbasierte Erfassungseinrichtung, die mit der Rotorbaugruppe 2, beispielsweise mit einem hier nicht dargestellten Permanentmagneten der Rotorbaugruppe, zur Erfassung des Drehwinkels der Rotorbaugruppe 2 gegenüber der Trägerbaugruppe 1 zusammenwirkt.

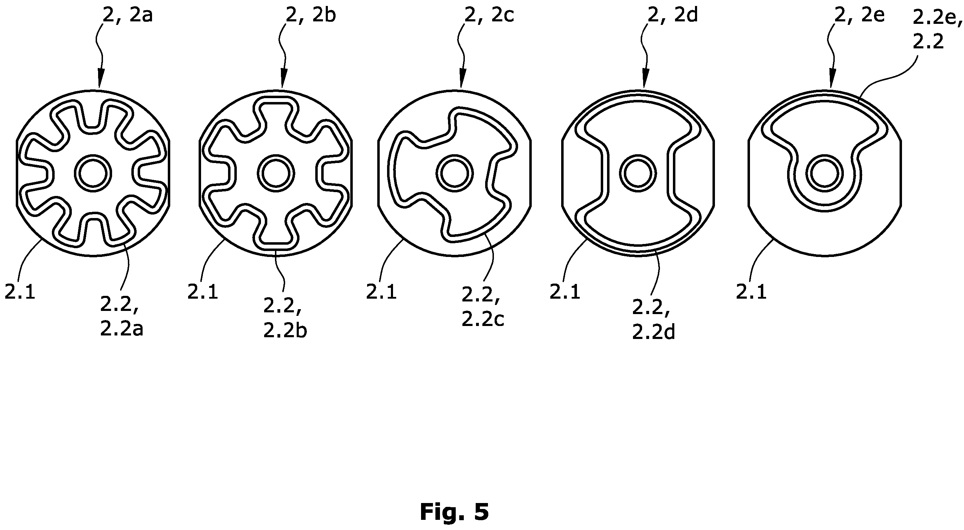

Fig. 5 zeigt beispielhaft fünf in einem erfindungsgemäßen modularen Baukastensystem zur Herstellung der Drehwinkelsensorvorrichtung 100 vorhandene unterschiedliche Konfigurationen 2a - 2e der Rotorbaugruppe 2.

Die einzelnen Konfigurationen 2a - 2e der Rotorbaugruppe 2 sind für unterschiedliche Drehwinkelmessbereiche ausgelegt, was sich durch unterschiedliche Konfigurationen 2.2a - 2.2e der Kurzschlusswicklung 2.2 der Rotorbaugruppe 2 ausdrückt.

Alle Konfigurationen 2a - 2e der Rotorbaugruppe 2 weisen hingegen einen im Wesentlichen identischen Rotorbaugruppengrundkörper 2.1 auf, sodass alle Konfigurationen 2a - 2e der Rotorbaugruppe 2 in dem Rotorraum 1.2 der Trägerbaugruppe 1 montiert werden können.

Grundsätzlich ist es auch vorstellbar, dass das erfindungsgemäße modulare Baukastensystem zusätzlich oder alternativ zu den unterschiedlichen Konfigurationen 2a - 2e der Rotorbaugruppe 2 auch andere Konfigurationen der Rotorbaugruppe 2, unterschiedliche Konfigurationen der ersten Leiterplattenbaugruppe 3 und/oder unterschiedliche Konfigurationen der zweiten Leiterplattenbaugruppe 4 umfasst.

Die Rotorbaugruppe 2 und die erste Leiterplattenbaugruppe 3 können beispielsweise jeweils in mehreren Konfigurationen vorhanden sein, die auf unterschiedlichen Sensortechnologien basieren.

Die erste Leiterplattenbaugruppe 3 und die zweite Leiterplattenbaugruppe 4 können ferner beispielsweise jeweils in mehreren Konfigurationen vorhanden sein, die für unterschiedliche Datenschnittstellen und/oder unterschiedliche Versorgungsspannungen ausgelegt sind.

Des Weiteren ist es beispielsweise auch vorstellbar, dass die zweite Leiterplattenbaugruppe 4 in mehreren Konfigurationen vorhanden ist, die sich hinsichtlich des Abstands, der Anzahl und/oder der Position der Anschlusskontakte 4.2.1 der Anschlusskontakteinrichtung 4.2 unterscheiden, um die Anbindung unterschiedlicher Anschlussstecker zu ermöglichen.

Ferner ist es auch vorstellbar, dass die zweite Leiterplattenbaugruppe 4 in eine Konfiguration mit der weiteren Erfassungseinrichtung 4.4 und in einer Konfiguration ohne die weitere Erfassungseinrichtung 4.4 vorhanden ist.

Grundsätzlich ist auch vorstellbar, dass sowohl die erste Leiterplattenbaugruppe 3 als auch die zweite Leiterplattenbaugruppe 4 in mehreren Konfigurationen vorhanden sind, die sich hinsichtlich der vorhandenen elektrischen und/oder elektronischen Komponenten und/oder deren Ausführung unterscheiden.

Zusammenfassend betrifft die Erfindung eine Drehwinkelsensorvorrichtung 100 umfassend: eine Trägerbaugruppe 1 mit einem Trägerbaugruppengrundkörper 1.1, der einen Rotorraum 1.2 bildet, eine Rotorbaugruppe 2, die drehbar gegenüber der Trägerbaugruppe 1 in dem Rotorraum 1.2 angeordnet ist, eine erste Leiterplattenbaugruppe 3, die an der Trägerbaugruppe 1 befestigt ist, und eine zweite Leiterplattenbaugruppe 4, die an der Trägerbaugruppe (1) befestigt ist, wobei die erste Leiterplattenbaugruppe 3 eine Erfassungseinrichtung 3.2 umfasst, die mit der drehbaren Rotorbaugruppe 2 zur Drehwinkelerfassung zusammenwirkt, wobei die zweite Leiterplattenbaugruppe 4 eine Anschlusskontakteinrichtung 4.2 zum Anschluss an ein externes System umfasst, und wobei die Trägerbaugruppe 1 eine Verbindungseinrichtung 1.5 umfasst, die an dem Trägerbaugruppengrundkörper 1.1 befestigt ist und eine elektrische Verbindung zwischen der ersten Leiterplattenbaugruppe 3 und der zweiten Leiterplattenbaugruppe 4 herstellt. Die vorliegende Erfindung betrifft ferner ein modulares Baukastensystem zur Herstellung einer derartigen Drehwinkelsensorvorrichtung 100, wobei mindestens eine der folgenden Baugruppen in mehreren unterschiedlichen Konfigurationen 2a - 2e vorhanden ist: die Rotorbaugruppe 2, die erste Leiterplattenbaugruppe 3 und die zweite Leiterplattenbaugruppe 4, wobei jede der unterschiedlichen Konfigurationen 2a - 2e ausgelegt ist, an der Trägerbaugruppe 1 montiert zu werden.

### Bezugszeichenliste

- 100: Drehwinkelsensorvorrichtung

- 1: Trägerbaugruppe
- 1.1: Trägerbaugruppengrundkörper
- 1.1.1: Deckenwandung
- 1.2: Rotorraum
- 1.2.1: Umfangswandung
- 1.3: Schnappeinrichtung
- 1.3.1: Schnappelemente
- 1.4: Taschen
- 1.5: Verbindungseinrichtung
- 1.5.1: Verbindungselemente

- 2: Rotorbaugruppe
- 2a - 2e: Konfigurationen der Rotorbaugruppe
- 2.1: Rotorbaugruppengrundkörper
- 2.1.1: Oberseite
- 2.1.2: Kante
- 2.1.3: Unterseite
- 2.2: Kurzschlusswicklung
- 2.2a - 2.2e: Konfigurationen der Kurzschlusswicklung
- 2.3: Kopplungseinrichtung

- 3: erste Leiterplattenbaugruppe
- 3.1: erste Leiterplatte
- 3.1.1: erste Verbindungskontakteinrichtung
- 3.1.1.1: Aufnahmen
- 3.2: Erfassungseinrichtung
- 3.2.1: Senderspule
- 3.2.2: Empfängerspulen
- 3.3: Auswerteelektronik

- 4: zweite Leiterplattenbaugruppe
- 4.1: zweite Leiterplatte
- 4.2: Anschlusskontakteinrichtung
- 4.2.1: Anschlusskontakte
- 4.3: Spannungsregeleinrichtung
- 4.4: weitere Erfassungseinrichtung

## Patentansprüche

1. Drehwinkelsensorvorrichtung (100) umfassend:
eine Trägerbaugruppe (1) mit einem Trägerbaugruppengrundkörper (1.1), der einen Rotorraum (1.2) bildet,
eine Rotorbaugruppe (2), die drehbar gegenüber der Trägerbaugruppe (1) in dem Rotorraum (1.2) angeordnet ist,
eine erste Leiterplattenbaugruppe (3), die an der Trägerbaugruppe (1) befestigt ist, und
eine zweite Leiterplattenbaugruppe (4), die an der Trägerbaugruppe (1) befestigt ist,
wobei die erste Leiterplattenbaugruppe (3) eine Erfassungseinrichtung (3.2) umfasst, die mit der drehbaren Rotorbaugruppe (2) zur Drehwinkelerfassung zusammenwirkt,
wobei die zweite Leiterplattenbaugruppe (4) eine Anschlusskontakteinrichtung (4.2) zum Anschluss an ein externes System umfasst, und
wobei die Trägerbaugruppe (1) eine Verbindungseinrichtung (1.5) umfasst, die an dem Trägerbaugruppengrundkörper (1.1) befestigt ist und eine elektrische Verbindung zwischen der ersten Leiterplattenbaugruppe (3) und
der zweiten Leiterplattenbaugruppe (4) herstellt.

2. Drehwinkelsensorvorrichtung nach Anspruch 1, wobei der Trägerbaugruppengrundkörper (1.1) einstückig ausgebildet ist.

3. Drehwinkelsensorvorrichtung (100) nach Anspruch 2, wobei der Trägerbaugruppengrundkörper (1.1) aus einem Kunststoff besteht.

4. Drehwinkelsensorvorrichtung (100) nach einem der vorhergehenden Ansprüche, wobei die Trägerbaugruppe (1) eine Wandung (1.1.1) umfasst, die zwischen der Rotorbaugruppe (2) und der ersten Leiterplattenbaugruppe (3) angeordnet ist.

5. Drehwinkelsensorvorrichtung (100) nach einem der vorhergehenden Ansprüche, wobei die Trägerbaugruppe (1) eine Schnappeinrichtung (1.3) umfasst, durch die die Rotorbaugruppe (2) in dem Rotorraum (1.2) gehalten wird.

6. Drehwinkelsensorvorrichtung (100) nach einem der vorhergehenden Ansprüche, wobei die Verbindungseinrichtung (1.5) von dem Trägerbaugruppengrundkörper (1.1) hervorstehende Verbindungselemente (1.5.1) umfasst, und wobei die erste Leiterplattenbaugruppe (3) und die zweite Leiterplattenbaugruppe (4) jeweils korrespondierend zu den Verbindungselementen (1.5) ausgebildete Aufnahmen (3.1.1) aufweisen, in die die Verbindungselemente (1.5) eingreifen.

7. Drehwinkelsensorvorrichtung (100) nach einem der vorhergehenden Ansprüche, wobei die erste Leiterplattenbaugruppe (3) und/oder die zweite Leiterplattenbaugruppe (4) über die Verbindungseinrichtung (1.5) an der Trägerbaugruppe (1) befestigt sind.

8. Drehwinkelsensorvorrichtung (100) nach einem der vorhergehenden Ansprüche, wobei die erste Leiterplattenbaugruppe (3) und die zweite Leiterplattenbaugruppe (4) an gegenüberliegenden Seiten der Trägerbaugruppe (1) angeordnet sind.

9. Drehwinkelsensorvorrichtung (100) nach einem der vorhergehenden Ansprüche, wobei die erste Leiterplattenbaugruppe (3) und/oder die zweite Leiterplattenbaugruppe (4) derart ausgebildet und angeordnet sind, dass durch die erste Leiterplattenbaugruppe (3) und/oder durch die zweite Leiterplattenbaugruppe (4) ein Herausfallen der Rotorbaugruppe (2) aus dem Rotorraum (1.2) verhindert wird.

10. Drehwinkelsensorvorrichtung (100) nach einem der vorhergehenden Ansprüche, wobei die erste Leiterplattenbaugruppe (3) eine Auswerteelektronik (3.3) umfasst, die ausgebildet ist, basierend auf einem von der Erfassungseinrichtung (3.2) bereitgestellten Messsignal einen Drehwinkel angebende Sensordaten zu bestimmen.

11. Drehwinkelsensorvorrichtung (100) nach einem der vorhergehenden Ansprüche, wobei die erste Leiterplattenbaugruppe (3) oder die zweite Leiterplattenbaugruppe (4) eine Spannungsregeleinrichtung (4.3) umfasst, die elektrisch mit der Anschlusskontakteinrichtung (4.2) verbunden ist, und die eingerichtet ist, eine definierte Versorgungsspannung bereitzustellen.

12. Drehwinkelsensorvorrichtung (100) nach einem der vorhergehenden Ansprüche, wobei die erste Leiterplattenbaugruppe (3) oder die zweite Leiterplattenbaugruppe (4) eine weitere Erfassungseinrichtung (4.4) umfasst, die mit der drehbaren Rotorbaugruppe (2) zur Drehwinkelerfassung zusammenwirkt.

13. Modulares Baukastensystem zur Herstellung einer Drehwinkelsensorvorrichtung (100) nach einem der vorhergehenden Ansprüche, wobei mindestens eine der folgenden Baugruppen in mehreren unterschiedlichen Konfigurationen (2a - 2e) vorhanden ist: die Rotorbaugruppe (2), die erste Leiterplattenbaugruppe (3) und die zweite Leiterplattenbaugruppe (4), wobei jede der unterschiedlichen Konfigurationen (2a - 2e) ausgelegt ist, an der Trägerbaugruppe (1) montiert zu werden.
